# EUROPEAN PATENT APPLICATION

(11) **EP 4 841 348 A1**
(43) Date of publication of application: **18.11.2026**
(21) Application number: 26176489.8
(22) Date of filing: 05.05.2026
(51) Int. Cl.: G03G 15/00, H04N 1/00

(54) **IMAGE FORMING APPARATUS**

(30) Priority: 12.05.2025 JP 2025079414
(71) Applicant: KYOCERA Document Solutions Inc., Osaka-shi, Osaka 540-8585 (JP)
(72) Inventor: SHINBA, Minoru, Osaka, 540-8585 (JP); SUGIYAMA, Yuichi, Osaka, 540-8585 (JP)
(74) Representative: Winter, Brandl - Partnerschaft mbB

(57) **Abstract**

An image forming apparatus includes plural power supply circuit boards. The plural power supply circuit boards are same power supply circuit boards as each other. Further, the power supply circuit boards are power supply circuit boards for another image forming apparatus of which a consumed electric power is less than a consumed electric power of this image forming apparatus.

## Description

### BACKGROUND

### 1. FIELD OF THE PRESENT INVENTION

The present invention relates to an image forming apparatus.

### 2. DESCRIPTION OF THE RELATED ART

An image forming apparatus includes plural power supply circuit boards in a power supply device, and outputs a low-voltage current at a constant voltage (24 Volt) to a motor or the like.

In general, such a power supply device is designed such that the power supply device has an electric power capacity corresponding to a consumed electric power of an image forming apparatus that includes this power supply device. Therefore, a power supply device of a high electric power capacity is developed for an image forming apparatus that performs an internal process at a high speed, and a power supply device of a low electric power capacity is developed for an image forming apparatus that performs an internal process at a low speed.

However, individual development of the power supply devices for machine types of different consumed electric powers as mentioned results in high development costs or high management costs.

### SUMMARY

An image forming apparatus according to the present invention includes plural power supply circuit boards. The plural power supply circuit boards are same power supply circuit boards as each other. Further, the power supply circuit boards are power supply circuit boards for another image forming apparatus of which a consumed electric power is less than a consumed electric power of this image forming apparatus.

These and other objects, features and advantages of the present invention will become more apparent upon reading of the following detailed description along with the accompanying drawings.

### BRIEF DESCRIPTION OF THE DRAWINGS

Fig. 1 shows a block diagram that indicates a configuration of an image forming apparatus according to Embodiment 1 of the present invention;
Fig. 2 shows a block diagram that indicates a configuration of the image forming apparatus according to Embodiment 2 of the present invention; and
Fig. 3 shows a circuit diagram that indicates an example of a configuration of a malfunction detecting circuit 31 in Fig. 2.

### DETAILED DESCRIPTION

Hereinafter, embodiments according to an aspect of the present invention will be explained with reference to drawings.

### Embodiment 1.

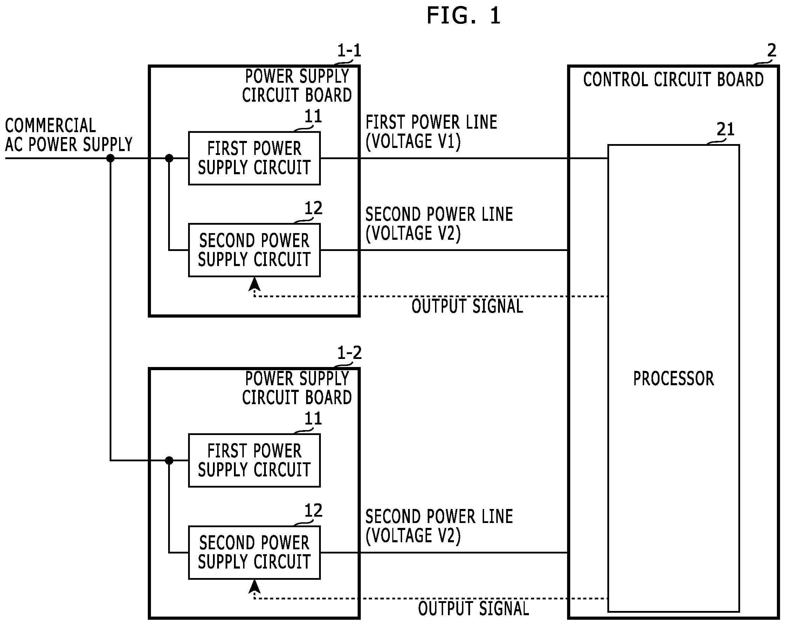

Fig. 1 shows a block diagram that indicates a configuration of an image forming apparatus according to Embodiment 1 of the present invention. The image forming apparatus shown in Fig. 1 includes plural power supply circuit boards 1-1 and 1-2, and a control circuit board 2.

The plural power supply circuit boards 1-1 and 1-2 are same power supply circuit boards as each other, and each power supply circuit board 1-i (i = 1, 2) is a power supply circuit board for another image forming apparatus of which a consumed electric power is less than a consumed electric power of this image forming apparatus. For example, this image forming apparatus is an image forming apparatus of which a process linear velocity is higher than the aforementioned other image forming apparatus.

The control circuit board 2 includes a processor 21 such as CPU (Central Processing Unit). The processor 21 executes a control program stored in a storage device not shown and thereby performs sorts of processes, and controls an internal device (printing device, image scanning device or the like) not shown and thereby performs sorts of jobs (print job, scan job, copy job and the like) and performs processes mentioned below.

Each power supply circuit board 1-i includes a first power supply circuit 11 and a second power supply circuit 12. The first power supply circuit 11 appropriately performs stepping-down, rectification, smoothing and the like for electric power from a commercial AC power supply and thereby outputs electric power at a first power supply voltage V1 (e.g. 5 Volt). The second power supply circuit 12 appropriately performs stepping-down, rectification, smoothing and the like for electric power from the commercial AC power supply and thereby outputs electric power at a second power supply voltage V2 (e.g. 24 Volt) that is different from the first power supply voltage V1.

The processor 21 operates with the electric power from the first power supply circuit 11 in any of the plural power supply circuit boards 1-1 and 1-2, and supplies an output signal to the second power supply circuit 12 in the plural power supply circuit boards 1-1 and 1-2 and thereby, turns on the second power supply circuits 12. It should be noted that the electric power may be supplied to the processor 21 at the first power supply voltage V1 (e.g. 5 Volt) or may be supplied to the processor 21 at a voltage (e.g. 3.3 Volt) lower than the first power supply voltage V1.

Specifically, the first power supply circuit 11 is automatically turned on when electric power is supplied from the commercial AC power supply at a predetermined voltage (AC100V, AC120V, AC230V or the like), and outputs a direct-current electric power at the first power supply voltage V1. Meanwhile, the second power supply circuit 12 is not automatically turned on even when electric power is supplied from the commercial AC power supply at a predetermined voltage (AC100V, AC120V, AC230V or the like), but when the output signal is supplied, the second power supply circuit 12 is turned on and outputs a direct-current electric power at the second power supply voltage V2.

The processor 21 may output a single output signal from a single port, and the single output signal may be supplied to the second power supply circuits 12 in the plural power supply circuit boards 1-1 and 1-2. In such a case, in accordance with the single output signal, the second power supply circuits 12 in the plural power supply circuit boards 1-1 and 1-2 are turned on.

The following part explains a behavior of the image forming apparatus 1 in Embodiment 1.

When electric power from the commercial AC power supply is supplied to the power supply circuit boards 1-1 and 1-2, the first power supply circuit 11 in the power supply circuit board 1-1 starts power supply to the control circuit board 2 at the first power supply voltage V1, and the processor 21 starts operation with the supplied electric power and outputs an output signal to the second power supply circuits 12 in the power supply circuit boards 1-1 and 1-2.

In the power supply circuit boards 1-1 and 1-2, when the output signal is supplied, each of the second power supply circuits 12 starts power supply to the control circuit board 12 and/or another internal device at the second power supply voltage V2. Consequently, electric power is supplied as a second power supply voltage V2 system from the plural second power supply circuits 12, and therefore, a large power supply capacity is obtained in total. Thus, even though a power supply capacity of only one power supply circuit board 1-i is smaller than a consumed electric power of this image forming apparatus, a total power supply capacity of the power supply circuit board 1-1 and 1-2 are larger than the consumed electric power of this image forming apparatus.

As mentioned, in the aforementioned Embodiment 1, this image forming apparatus includes plural power supply circuit boards 1-1 and 1-2, the plural power supply circuit boards 1-1 and 1-2 are same as each other, and the power supply circuit board 1-i is a power supply circuit board for another image forming apparatus of which consumed electric power is less than consumed electric power of this image forming apparatus.

Consequently, the power supply circuit boards are commonized, and a development cost and a management cost of the power supply devices are restrained because of economies of scale.

### Embodiment 2.

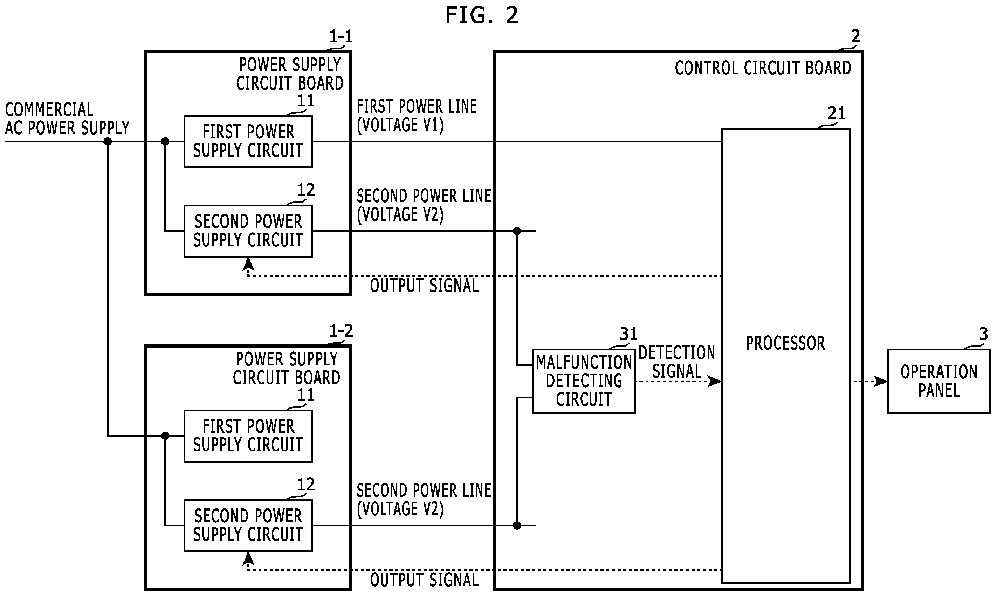

Fig. 2 shows a block diagram that indicates a configuration of the image forming apparatus according to Embodiment 2 of the present disclosure. As shown in Fig. 2, the image forming apparatus in Embodiment 2 further includes an operation panel 3. The operation panel 3 includes a display device that displays various information to a user, and an input device that detects a user operation. Further, in Embodiment 2, the control circuit board 2 further includes a malfunction detecting circuit 31.

The malfunction detecting circuit 31 operates with the electric power from the first power supply circuit 11 in any of the plural power supply circuit boards 1-1 and 1-2; and if an output voltage of one of the second power supply circuits 12 is lower than a predetermined threshold value when the second power supply circuits 12 are in power-on state by the output signal, the malfunction detecting circuit 31 supplies a detection signal that indicates a malfunction to the processor 21. The processor 21 detects a malfunction of the power supply circuit board 1-1 or 1-2 (damage of the power supply circuit board 1-i, connection failure between the power supply circuit board 1-i and the control circuit board 2, or the like) on the basis of the detection signal.

The aforementioned threshold value may be equal to the second power supply voltage V2 or may be a voltage lower by a predetermined allowable width than the second power supply voltage V2. Further, the electric power may be supplied to the malfunction detecting circuit 31 at the first power supply voltage V1 (e.g. 5 Volt) or may be supplied to the malfunction detecting circuit 31 at a voltage (e.g. 3.3 Volt) lower than the first power supply voltage V1.

In this embodiment, the malfunction detecting circuit 31 derives a logical sum of plural logical values of which each indicates whether an output voltage of one of the second power supply circuits 12 is less than a predetermined threshold value or not when the second power supply circuits 12 are in power-on state by the output signal. Further, the detection signal is input as a single signal that indicates the logical sum to the processor 21 through a single port of the processor 21.

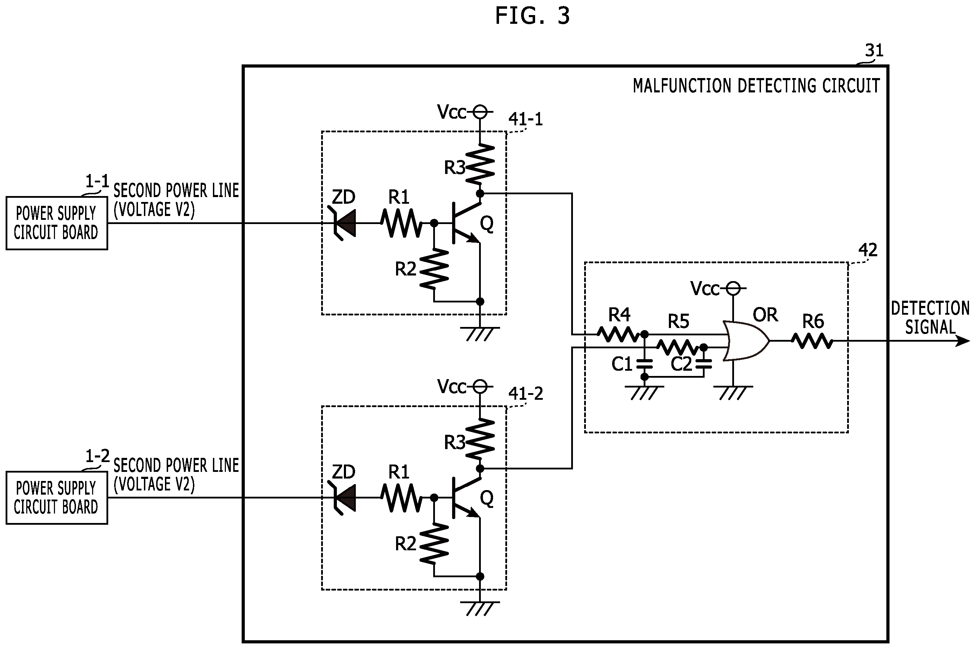

Fig. 3 shows a circuit diagram that indicates an example of a configuration of the malfunction detecting circuit 31 in Fig. 2. The malfunction detecting circuit 31 shown in Fig. 3 includes plural voltage detection circuits 41-1 and 41-2, and a logical sum circuit 42.

The plural voltage detection circuits 41-1 and 41-2 are circuits that determine whether output voltages of the second power supply circuits 12 in the plural power supply circuit boards 1-1 and 1-2 are lower than a predetermined threshold value or not, respectively.

Each voltage detection circuit 41-i includes a Zener diode ZD, resistors R1 to R3, and a transistor Q as a switching element. If the output voltage of the second power supply circuit 12 is equal to or higher than a predetermined threshold value, then even though there is voltage drop at the Zener diode ZD, the transistor Q is turned on and the output voltage of the voltage detection circuit 41-i has a low level (here, ground level). Conversely, if the output voltage of the second power supply circuit 12 is lower than the predetermined threshold value, then due to voltage drop at the Zener diode ZD, an emitter-base voltage of the transistor Q is lower than an operation voltage of the transistor Q, and thereby the transistor Q is turned off and the output voltage of the voltage detection circuit 41-i has a high level (here, power supply voltage Vcc level).

The logical sum circuit 42 includes resistors R4 to R6, capacitors C1 and C2, and a logical sum element OR. The logical sum circuit 42 calculates a logical sum of the output voltages of the voltage detection circuits 41-1 and 41-2 using the logical sum element OR, and outputs the calculation result as the detection signal to the processor 21. Here, the resistor R4 and the capacitor C1 are a high-cut filter, and restrains noise (level fluctuation in a short time, or the like) in the output voltage of the voltage detection circuit 41-1; and the resistor R5 and the capacitor C2 are a high-cut filter, and restrains noise (level fluctuation in a short time, or the like) in the output voltage of the voltage detection circuit 41-2. The resistor R6 is an output resistor.

The following part explains a behavior of the image forming apparatus in Embodiment 2.

When the second power supply circuits 12 in the plural power supply circuit boards 1-1 and 1-2 start power supply as well as in Embodiment 1, the malfunction detecting circuit 31 always monitors voltages of power supply lines from the second power supply circuits 12 as mentioned, and if the output voltage of at least one of the second power supply circuits 12 decreases, the malfunction detecting circuit 31 outputs the detection signal to the processor 21.

The processor 21 detects a malfunction of the power supply circuit boards 1-1 and 1-2 on the basis of the detection signal, and upon detecting the malfunction, displays an error message on the operation panel 3 (display device).

Other parts of the configuration and behaviors of the image forming apparatus in Embodiment 2 are identical or similar to those in Embodiment 1, and therefore not explained here.

It should be understood that various changes and modifications to the embodiments described herein will be apparent to those skilled in the art. Such changes and modifications may be made without departing from the spirit and scope of the present subject matter and without diminishing its intended advantages. It is therefore intended that such changes and modifications be covered by the appended claims.

For example, in the aforementioned embodiments, the number of the power supply circuit boards 1-1 and 1-2 is 2, but alternatively, the number of the power supply circuit boards 1-1 and 1-2 may be 3 or more.

## Claims

1. An image forming apparatus, comprising
plural power supply circuit boards (1-1, 1-2);
wherein the plural power supply circuit boards (1-1, 1-2) are same power supply circuit boards as each other; and
the power supply circuit boards (1-1, 1-2) are power supply circuit boards for another image forming apparatus of which a consumed electric power is less than a consumed electric power of this image forming apparatus.

2. The image forming apparatus according to claim 1, further comprising a processor (21);
wherein the power supply circuit board (1-1, 1-2) comprises a first power supply circuit (11) configured to output electric power at a first power supply voltage, and a second power supply circuit (12) configured to output electric power at a second power supply voltage that is different from the first power supply voltage; and
the processor (21) operates with the electric power from the first power supply circuit (11) in any of the plural power supply circuit boards (1-1, 1-2), and supplies an output signal to the second power supply circuit (12) in the plural power supply circuit boards (1-1, 1-2) and thereby, turns on the second power supply circuits (12).

3. The image forming apparatus according to claim 2, wherein the processor (21) outputs a single output signal;
the single output signal is supplied to the second power supply circuits (12) in the power supply circuit boards (1-1, 1-2); and
the second power supply circuits (12) in the power supply circuit boards (1-1, 1-2) are turned on in accordance with the single output signal.

4. The image forming apparatus according to claim 2, further comprising a malfunction detecting circuit (31);
wherein the malfunction detecting circuit (31) operates with the electric power from the first power supply circuit (11) in any of the plural power supply circuit boards (1-1, 1-2), and if an output voltage of one of the second power supply circuits (12) is lower than a predetermined threshold value when the second power supply circuits (12) are in power-on state by the output signal, supplies a detection signal that indicates a malfunction to the processor (21); and
the processor (21) detects a malfunction of the power supply circuit board (1-1, 1-2) on the basis of the detection signal.

5. The image forming apparatus according to claim 4, wherein the malfunction detecting circuit (31) derives a logical sum of plural logical values of which each indicates whether an output voltage of one of the second power supply circuits (12) is lower than a predetermined threshold value or not when the second power supply circuits (12) are in power-on state by the output signal; and
the detection signal is input as a single signal that indicates the logical sum to the processor (21).
